# NEUE EUROPÄISCHE PATENTSCHRIFT

(11) **EP 1 631 996 B2**
(45) Veröffentlichungstag und Bekanntmachung des Hinweises auf die Entscheidung über den Einspruch: **07.08.2013**
(45) Hinweis auf die Patenterteilung: 11.03.2009
(21) Anmeldenummer: 04734848.7
(22) Anmeldetag: 26.05.2004
(51) Int. Cl.: H01L 51/30

(54) **ORGANISCHE SOLARZELLE MIT EINER ZWISCHENSCHICHT MIT ASYMMETRISCHEN TRANSPORTEIGENSCHAFTEN**
ORGANIC SOLAR CELL COMPRISING AN INTERMEDIATE LAYER WITH ASYMMETRICAL TRANSPORT PROPERTIES
CELLULE SOLAIRE ORGANIQUE A COUCHE INTERMEDIAIRE AUX PROPRIETES DE TRANSPORT ASYMETRIQUES

(30) Priorität: 12.06.2003 DE 10326546
(43) Veröffentlichungstag der Anmeldung: 08.03.2006
(60) Teilanmeldung: 09153801.7
(73) Patentinhaber: Merck Patent GmbH, 64293 Darmstadt (DE)
(72) Erfinder: BRABEC, Christoph, 91054 Erlangen (DE); WALDAUF, Christoph, 91056 Erlangen (DE)
(86) Internationale Anmeldenummer: PCT/EP2004/050915
(87) Internationale Veröffentlichungsnummer: WO 2004/112162

(56) Entgegenhaltungen:
- WO-A-01/84644
- US-A1- 2002 119 297

## Beschreibung

Die vorliegende Erfindung betrifft eine organische Solarzelle mit einer photoaktiven Schicht aus zwei molekularen Komponenten, nämlich einem Elektronendonator und einem Elektronenakzeptor und mit zwei beidseits der photoaktiven Schicht vorgesehenen Elektroden.

Bei organischen Solarzellen und Photodetektoren (insbesondere bulk heterojunction Polymer-Solarzellen) wird eine Verringerung des Parallelwiderstandes mit zunehmender Beleuchtungsintensität beobachtet. Dieses Phänomen wird als Photo-Shunt bezeichnet. Der Photo-Shunt führt zu einer Reduzierung des Füllfaktors und damit zu einer Reduzierung der Effizienz der Solarzelle.

Eine Möglichkeit, den Serienwiderstand und die Selektivität der Kontakte zu erhöhen, ist aus der WO 01/84645 A1 bekannt.

Die WO-A-01/84644 offenbart eine photovoltaische Zelle mit einer photoaktiven Schicht (4), die aus zwei molekularen Komponenten besteht, einer konjugierten Polymerkomponente als Elektronendonator und einer Fullerenkomponente als Elektronenakzeptor. Die photovoltaische Zelle umfasst weiterhin zwei Metallelektroden (2, 6), welche an beiden Seiten der photovoltaischen Schicht (4) angeordnet sind. In einer vorteilhaften Ausführungsform ist eine Zwischenschicht (5) zwischen der photoaktiven Schicht (4) und wenigstens einer Elektrode (2, 6) vorgesehen. Diese Zwischenschicht besteht aus einem konjugierten Polymer, das eine Dotierung aufweist, die dem Elektrodenpotential entspricht, und das eine Bandlücke hinsichtlich der Elektronenenergiebänder von wenigstens 1,8 eV zwischen dem Valenzband und dem Leitungsband aufweist.

US 2002/119297 A1 offenbart eine organische photosensitive optoelektronische Vorrichtung, welche optimiert ist gewünschte Eigenschaften, wie externe Quanteneffizienz, zu verbessern. Die photosensitive optoelektronische Vorrichtung weist wenigstens zwei transparente Elektroden und eine oder mehrere organische photoleitende Schichten auf, die zwischen den transparenten Elektroden angeordnet sind.

Es sind bisher jedoch keine Lösungen bekannt, die geeignet sind, den Parallelwiderstand zu erhöhen.

Es ist daher eine Aufgabe der vorliegenden Erfindung, den Parallelwiderstand einer organischen Solarzelle zu erhöhen, um die durch einen geringen Parallelwiderstand entstehenden Verluste zu verringern.

Diese Aufgabe wird gemäß der Erfindung durch eine photovoltaische Zelle gemäß Patentanspruch 1 gelöst. Die abhängigen Ansprüche enthalten vorteilhafte Ausgestaltungen der Erfindung.

Der Ausdruck "asymmetrische Leitfähigkeit" bezeichnet eine asymmetrische Mobilität für die unterschiedlichen Ladungsträger. Ein Vorteil besteht darin, dass bei einer geeigneten Wahl des Materials der Zwischenschicht besonders bei organischen Solarzellen keine Dotierung der Zwischenschicht notwendig ist. Damit können auch alle Nachteile, wie Stabilisierungsprobleme mit den Dotierungen, besonders in organischen Schichten vermieden werden.

Bevorzugt hat die Zwischenschicht eine (große) Bandlücke, die zumindest gleich oder größer ist als die Bandlücke der photoaktiven Schicht. Sie liegt beispielsweise in dem Bereich von 1,7 bis 6,1 eV (Elektronenvolt) oder bevorzugt in einem Bereich von 2,5 bis 3,7 eV.

Eine Schicht mit einer großen Bandlücke ist bevorzugt zumindest semi-transparent oder gar transparent.

Wenn eine solche Schicht verwendet wird, kann verhindert werden, dass eine Art von Ladungsträger (Elektronen oder Defektelektronen (bzw. Fehlstellen oder Löcher) von einer Elektrode zu der anderen Elektrode gelangen können. Dadurch lässt sich der Parallelwiderstand (zumindest für eine Ladungsträgerart) beträchtlich erhöhen.

In einer bevorzugten Ausgestaltung der Erfindung weist die Photovoltaische Zelle zwischen beiden Elektroden und der photoaktiven Schicht jeweils eine Zwischenschicht mit großer Bandlücke und asymmetrischer Leitfähigkeit auf.

Eine Schicht mit einer großen Bandlücke ist im Wesentlichen transparent oder zumindest semi-transparent. Der Ausdruck "asymmetrische Leitfähigkeit," bezeichnet eine asymmetrische Mobilität für die unterschiedlichen Ladungsträger. Wenn zwei solche Schichten verwendet werden, kann eine Schicht Elektronen und eine Schicht Defektelektronen leiten. Durch die Schaltung der beiden Schichten in Reihe lässt sich der Paral lelwiderstand für beide Ladungsträgerarten beträchtlich erhöhen. Damit lässt sich verhindern, dass eine der beiden Padungsträgerarten von einer Elektrode zu der anderen Elektrode gelangen kann. Damit lassen sich auch Verluste durch Rekombination von Minoritätsladungsträgern in den Elektroden der Solarzelle verringern.

Gemäß einem ersten Aspekt der Erfindung weist die photoaktive Schicht einen Bereich mit Elektronendonatoren und einen Bereich mit Elektronenakzeptoren auf. Der Bereich der Elektronenakzeptoren ist der Kathode zugeordnet. Die Photovoltaische Zelle ist dadurch gekennzeichnet, dass die Zwischenschicht zwischen dem Bereich der Elektronenakzeptoren und der Kathode (negative Elektrode) angeordnet ist und ein Material aufweist, das Strom hauptsächlich durch Elektronen leitet.

Gemäß einem zweiten Aspekt der Erfindung weist die photoaktive Schicht einen Bereich mit Elektronendonatoren und einen Bereich mit Elektronenakzeptoren auf. Der Bereich der Elektronendonatoren ist der Anode (positive Elektrode) zugeordnet. Die Photovoltaische Zelle ist dadurch gekennzeichnet, dass die Zwischenschicht zwischen dem Bereich der Elektronendonatoren und der Anode angeordnet ist und ein Material aufweist, das Strom hauptsächlich durch Defektelektronen (Löcher, pos. Ladungen) leitet.

Damit ist die Asymmetrie der Leitfähigkeit einer der Elektroden bzw. einer der aktiven Schichten zugeordnet. Das heißt, dass zwischen der Kathode und dem Bereich der Elektronenakzeptoren eine Schicht eines Elektronenleiters angeordnet ist. Dass heißt auch, dass zwischen der Anode und dem Bereich der Elektronendonatoren eine Schicht eines Defektelektronen-Leiters angeordnet ist..

In einer Ausgestaltung des ersten Aspekts der Erfindung umfasst die elektronenleitende Zwischenschicht zwischen den Elektronenakzeptoren und der Kathode TiO₂ oder C₆₀.

In einer Ausgestaltung der zweiten Aspekts der Erfindung ist die Photovoltaische Zelle dadurch gekennzeichnet, dass die Defektelektronen-leitende Zwischenschicht PEDOT umfasst. PEDOT (Poly-3,4-ethylendioxythiophen) ist ein leitendes Polymer, das auf einem heterocyclischen Thiophen basiert der durch Dietherbrücken polymerisiert.

Eine weitere Ausgestaltung des ersten Aspekts der vorliegenden Erfindung ist dadurch gekennzeichnet, dass das Leitungsband der elektronenleitenden Zwischenschicht auf das höchste besetzte Molekülorbital des Elektronenakzeptors abgestimmt ist. Dadurch wird vermieden, das sich Potentialdifferenzen zwischen der Zwischenschicht und dem Bereich der Elektronenakzeptoren ausbilden können, die sich negativ auf die Leistung bzw. den Wirkungsgrad der Solarzelle auswirken können.

Eine andere Ausgestaltung des zweiten Aspekts der vorliegenden Erfindung ist dadurch gekennzeichnet, dass das Leitungsband der Defektelektronen (LÖCHER)-leitenden Zwischenschicht auf das niedrigste unbesetzte Molekülorbital des Elektronendonators abgestimmt ist. Dadurch wird vermieden, dass sich Potentialdifferenzen zwischen der Zwischenschicht und dem Bereich der Elektronendonatoren ausbilden können, die sich negativ auf die Leistung bzw. den Wirkungsgrad der Solarzelle auswirken können.

Bevorzugt ist die erfindungsgemäße Photovoltaische Zelle eine organische Photovoltaische Zelle.

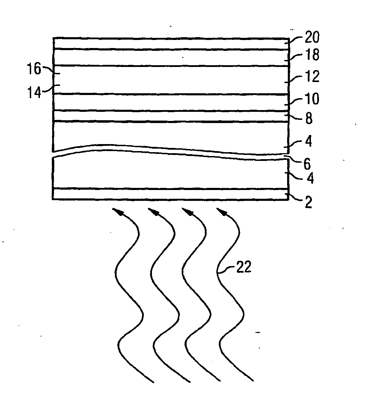

Im Folgenden wird die Erfindung anhand der beigefügten Zeichnung beschrieben, wobei
Fig. 1 eine Schnittansicht durch eine Solarzelle gemäß einer Ausführungsform der vorliegenden Erfindung darstellt.

Figur 1 stellt einen Querschnitt durch eine Solarzelle gemäß der vorliegenden Erfindung dar. Die Solarzelle ist auf einem Trägermaterial bzw. einem Substrat 4 aufgebracht. Das Substrat 4 kann aus Glas, Kunststoff, einem Kristall oder einem ähnlichen Material bestehen. Das Substrat 4 ist mit einer Bruchlinie 6 dargestellt, um zu zeigen, dass die Dicke des Substrats 4 für die vorliegende Erfindung unerheblich ist und variieren kann. Das Substrat dient lediglich dazu, der Solarzelle eine entsprechende mechanische Festigkeit und eventuell einen Oberflächenschutz zur Verfügung zu stellen. Das Substrat ist auf der dem Lichteinfall zugewandten Seite mit einer Antireflexbeschichtung 2 (bzw. Vergütung) versehen, um Verluste durch Reflexion zu vermeiden.

Die erste Schicht 8 auf dem Substrat stellt eine Elektrode 8 der Solarzelle dar. Es ist im Wesentlichen nicht wichtig, ob die Elektrode eine Kathode oder eine Anode ist.

Ohne Beschränkung sei angenommen, dass das Licht von unten durch das Substrat 4 in die dargestellte Solarzelle eintritt. Die erste Elektrode 8 sollte daher beispielsweise aus Al, Cu, ..., ITO (Indium-tin-oxide) oder dergleichen bestehen. Es ist zu beachten, dass die dem Lichteinfall zugewandte Elektrode (hier die Elektrode 8) vorzugsweise durchsichtig bzw. semi-transparent ist und/oder eine Gitterstruktur aufweist.

Es sei zur Einfachheit angenommen, dass die auf dem Substrat 4 angeordnete Elektrode 8 eine Kathode ist. Auf der Kathode ist eine erste Zwischenschicht 10 mit großer Bandlücke und asymmetrischer Leitfähigkeit, d. h. einer Leitfähigkeit, die durch die Beweglichkeit von (Überschuss-) Elektronen bereitgestellt wird, aufgebracht. Durch die große Bandlücke ist das Material im Wesentlichen transparent oder zumindest semi-transparent. Durch diese Zwischenschicht können sich nur Elektronen bewegen. Das Material und die Abmessungen der ersten Zwischenschicht 10 können dabei so gewählt werden, dass sie zu den Eigenschaften der aktiven Schicht bzw. des Elektronenakzeptors passen. Bei organischen Solarzellen kann dies durch Anpassen der Bandlücke an das höchste besetzte Molekülorbital des Elektronenakzeptors erreicht werden.

Die weiteren Eigenschaften der Zwischenschicht 10, wie Dicke und Brechungsindex können so gewählt sein, dass die Zwischenschicht 10 als eine Antireflexions-Schicht zwischen der Elektrode 8 und der darauf folgenden Schicht wirkt.

Es ist zu beachten, dass die dem Lichteinfall zugewandte Zwischenschicht 10 vorzugsweise die Elektrode 8 eine Gitterstruktur aufweisen kann.

Die Zwischenschicht 10 wird von der aktiven Schicht selbst überzogen. Die Zusammensetzung der aktiven Schicht 12 ist für die vorliegende Erfindung im Wesentlichen nicht wichtig. Aktive Schichten weisen üblicherweise einen Bereich mit Elektronendonatoren 16 und einen Bereich mit Elektronenakzeptoren 14 auf, die beide beispielsweise über eine Verarmungsschicht miteinander durchmischt sind und/oder miteinander verbunden sind. Die in der aktiven Schicht durch Lichteinfall erzeugten Ladungsträger (Elektronen-Loch-Paare) werden jeweils getrennt in die angrenzenden Schichten abgesaugt.

Die aktive Schicht besteht aus einer konjugierten Polymer-Komponente und einer Fulleren-Komponente.

Bei der dargestellten Solarzelle ist die dem Substrat zugewandte Seite 14 der aktiven Schicht 12 dem Elektronenakzeptor und die dem Substrat abgewandte Seite 16 dem Elektronendonator zugeordnet.

Über der aktiven Schicht 12 ist auf der Seite der Elektronendonatoren 16 eine zweite Zwischenschicht 18 mit großer Bandlücke und asymmetrischer Leitfähigkeit angeordnet. Die Leitfähigkeit der zweiten Zwischenschicht 18 basiert auf der Beweglichkeit von Defektelektronen. Durch die große Bandlücke ist das Material ebenfalls im Wesentlichen transparent oder zumindest semi-transparent. Durch diese Zwischenschicht können sich nur Defektelektronen bewegen. Das Material und die Abmessungen der zweiten Zwischenschicht 18 können dabei so gewählt werden, dass sie zu den Eigenschaften der aktiven Schicht bzw. den Eigenschaften des Elektronendonators passen. Bei organischen Solarzellen kann dies durch Anpassen der Bandlücke der Zwischenschicht an das niedrigste unbesetzte Molekülorbital des Elektronendonators erreicht werden.

Zusammenfassend lässt sich sagen, dass durch die beiden in Reihe geschalteten asymmetrisch leitenden Zwischenschichten 10 und 18 weder ein Elektron noch ein Defektelektron direkt von einer Elektrode zu der anderen Elektrode gelangen kann, da entweder die erste Zwischenschicht oder die zweite Zwischenschicht eine undurchdringliche Barriere darstellen. Somit kann kein Ladungsträger direkt von der einen zu der andern Elektrode gelangen. Damit erhöht sich der Parallelwiderstand im Vergleich zu einer konventionell aufgebauten Solarzelle und damit erhöht sich auch der Wirkungsgrad der Solarzelle.

Die weiteren Eigenschaften der Zwischenschicht 18 wie Dicke und Brechungsindex können so gewählt sein, dass die Zwischenschicht 18 eine Antireflexions-Schicht zwischen der aktiven Schicht 12 und der darauf folgenden Schicht bildet. Dies kann besonders bei Photovoltaischen Tandem- oder Multi-Zellen vorteilhaft sein.

Die weiteren Eigenschaften der Zwischenschicht 18 wie Dicke und Brechungsindex können so gewählt sein, dass die Zwischenschicht 18 (zusammen mit einer darauf folgenden Elektrode) eine Reflexionsschicht zwischen der aktiven Schicht 12 und der darauf folgenden Schicht bildet. Dies kann besonders bei photovoltaischen Einzelzellen vorteilhaft sein, da Licht, das die aktive Schicht passiert hat, nach der Reflexion noch einmal Ladungsträgerpaare in der Verarmungsschicht erzeugen kann.

Die dem Lichteinfall abgewandte Zwischenschicht (je nach Ausführung 10 oder 18) muss nicht notwendiger weise transparent oder semi-transparent sein. Dies bedeutet, dass die Bandlücke der Zwischenschicht, die dem Lichteinfall abgewandt ist, nicht unbedingt groß sein muss.

Die dem Lichteinfall zugewandte Zwischenschicht (je nach Ausführung 10 oder 18) hingegen muss transparent oder zumindest semi-transparent sein, damit das einfallende Licht zu der aktiven Schicht gelangen kann. Dies bedeutet, dass die Bandlücke der Zwischenschicht, die dem Lichteinfall zugewandt ist, mindestens genau so groß sein muss wie die Bandlücke des Materials der aktiven Schicht, das dem Lichteinfall zugewandt ist.

Nach der zweiten Zwischenschicht 18 folgt die Elektrodenschicht 20, die in dem gegebenen Beispiel eine Anode darstellt. Das Elektrodenmaterial der Anode kann in der vorliegenden Ausführungsform beispielsweise aus Ag, Au, Al, Cu, ... ITO oder dergleichen bestehen. Da die Anode in dem vorliegenden Beispiel dem Lichteinfall abgewandt ist, unterliegt sie keinerlei Beschränkungen hinsichtlich der Dicke, der Transparenz oder irgendwelcher anderen Beschränkungen. Die Anode kann des Weiteren noch von einer (nicht gezeigten) Schutzschicht überzogen sein.

Die gewellten Pfeile 22 deuten die Richtung des Lichteinfalls an.

Selbstverständlich kann die Solarzelle auch umgekehrt auf einem beispielsweise undurchsichtigen Substrat 4 aufgebaut werden, wobei das Licht dann von oben einfallen kann. Ein solcher "inverser" Aufbau bringt jedoch den Nachteil mit sich, dass die dem Lichteinfall zugewandten Strukturen und Schichten den Umwelteinflüssen wie Luftsauerstoff, Staub und dergleichen ausgesetzt sind, was die Solarzelle schnell beschädigen oder unbrauchbar machen kann.

Bei einem "inversen" Aufbau wäre beispielsweise die Antireflexbeschichtung 2 auf der anderen Seite der Solarzelle vorzusehen.

Die vorliegende Erfindung kann auch bei konventionellen monokristallinen oder polykristallinen Solarzellen angewendet werden. Dabei würden die Zwischenschichten 10, 18 wiederum zwischen den Elektroden und der aktiven Schicht angeordnet werden.

Die vorliegende Erfindung ermöglicht es, den Parallelwiderstand von Solarzellen und Photodetektoren zu erhöhen. Dadurch lässt sich der Effekt des "Photo-Shunts" verringern und dadurch der Füllfaktor und damit die Effizienz der Solarzelle erhöhen. Damit steigt auch die Idealität der Diode.

Die Zwischenschichten können sowohl aus der Gasphase als auch aus einer Lösung abgeschieden werden, was die Verarbeitung bzw. die Erzeugung der Zwischenschichten verbilligt.

Bei der Verwendung von (semi-)transparenten Schichten mit großem Bandabstand (Bandgap) und stark asymmetrischer Leitfähigkeit zwischen der Elektrode und der photoaktiven Halbleiterschicht ist zu beachten, dass die Schicht mit hoher Elektronenmobilität zwischen der aktiven Schicht und der negativen Elektrode, und die Schicht mit hoher Löcher- (Defektelektronen-) Mobilität zwischen der aktiven Schicht und der positiven Elektrode aufgebracht wird. Es ist weiterhin zu beachten, dass das Leitungsband der Schicht mit hoher Elektronenmobilität an das höchste besetzte Molekülorbital des Elektronenakzeptors, und dass das Valenzband der Schicht mit hoher Löchermobilität an das niedrigste unbesetzte Molekülorbital des Elektronendonators angepasst wird.

Bei einer ausreichenden Mobilität der Ladungsträger in den Zwischenschichten ist eine zusätzliche Dotierung nicht notwendig.

Es ist weiterhin ersichtlich, dass sich die Bandlücken der mindestens zwei Zwischenschichten unterscheiden können. Es ist weiterhin einsichtig, dass auch Konstruktionen mit mehreren Zwischenschichten unter den Schutzbereich der vorliegenden Ansprüche fallen sollen, da solche mehrlagigen Zwischenschichten auch als eine einzelne "Verbund-Zwischenschicht" betrachtet werden können. Es ist weiterhin deutlich, dass die vorliegende Erfindung selbstverständlich auch bei Tandem oder Multi-Solarzellen versendet werden kann. Bei der Betrachtung der einzelnen Solarzellen-Schichten als auch der Tandemsolarzelle insgesamt, fallen auch alle möglichen Kombinationen mit mindestens einer Zwischenschicht zwischen einer photoaktiven Schicht und einer Elektrode als auch Konstruktionen mit einer Zwischenschicht zwischen jeder photoaktiven Schicht und jeder Elektrode unter den Schutzumfang der vorliegenden Ansprüche.

Durch die asymmetrischen Transporteigenschaften der Zwischenschichten wird die Ausbildung durchgehender Leitpfade für nur eine Ladungsträgerart verhindert. Dadurch erhöht sich der Parallelwiderstand. Dadurch werden gleichzeitig die Wahrscheinlichkeit, dass Minoritätsladungsträger die jeweils andere Elektrode erreichen, und somit Verluste durch Rekombination von Ladungsträgern entgegengesetzter Ladung in den Metallelektroden verringert.

## Patentansprüche

1. Organische photovoltaische Zelle mit einer photoaktiven Schicht (12) aus einer konjugierten Polymer-Komponente und einer Fulleren-Komponente und zwei Elektroden (8, 20), wobei zwischen zumindest einer der Elektroden und der photoaktiven Schicht (12) eine Zwischenschicht (10) mit asymmetrischer Leitfähigkeit angeordnet ist, wobei asymmetrische Leitfähigkeit eine asymmetrische Mobilität für die unterschiedlichen Ladungsträger bezeichnet, und wobei die photoaktive Schicht (12) einen Bereich mit Elektronendonatoren (16) und einen Bereich mit Elektronenakzeptoren (14) aufweist, wobei dem Bereich der Elektronenakzeptoren (14) eine Kathode (8) zugeordnet ist,
**dadurch gekennzeichnet, dass** die Zwischenschicht (10) zwischen dem Bereich der Elektronenakzeptoren (14) und der Kathode (8) angeordnet ist und ein Material aufweist, das Strom hauptsächlich über Elektronen leitet, wobei die Leitfähigkeit der Zwischenschicht durch die Beweglichkeit von Elektronen bereitgestellt wird.

2. Photovoltaische Zelle gemäß Anspruch 1, **dadurch gekennzeichnet, dass** die elektronenleitende Zwischenschicht (10) TiO₂ oder C₆₀ umfasst.

3. Photovoltaische Zelle gemäß Anspruch 1 oder 2, **dadurch gekennzeichnet, dass** das Leitungsband der elektronenleitenden Zwischenschicht (10) auf das höchste besetzte Molekülorbital des Elektronenakzeptors abgestimmt ist.

4. Photovoltaische Zelle gemäß Anspruch 1, wobei dem Bereich der Elektronendonatoren (16) eine (20) Anode zugeordnet ist,
**dadurch gekennzeichnet, dass** eine Zwischenschicht (18) zwischen dem Bereich der Elektronendonatoren (16) und der Anode (20) angeordnet ist und ein Material aufweist, das Strom hauptsächlich über Defektelektronen leitet.

5. Photovoltaische Zelle gemäß Anspruch 4, **dadurch gekennzeichnet, dass** die Defektelektronenleitende Zwischenschicht (18) PDOT umfasst.

6. Photovoltaische Zelle gemäß Anspruch 4 oder 5, **dadurch gekennzeichnet, dass** das Valenzband der Defektelektronenleitenden Zwischenschicht (18) auf das niedrigste unbesetzte Molekülorbital des Elektronendonators abgestimmt ist.

7. Photovoltaische Zelle gemäß einem der vorhergehenden Ansprüche, **dadurch gekennzeichnet, dass** die Zwischenschicht (10, 18) eine Bandlücke aufweist, die größer als oder gleich der Bandlücke der photoaktiven Schicht (12) ist.

8. Photovoltaische Zelle gemäß einem der vorhergehenden Ansprüche, **dadurch gekennzeichnet, dass** die Zwischenschicht (10, 18) semitransparent ist.

## Claims

1. Organic photovoltaic cell having a photoactive layer (12) comprising a conjugated polymer component and a fullerene component and two electrodes (8, 20), where an interlayer (10) having asymmetrical conductivity is arranged between at least one of the electrodes and the photoactive layer (12), where asymmetrical conductivity denotes asymmetrical mobility for the different charge carriers, and where the photoactive layer (12) has a region comprising electron donors (16) and a region comprising electron acceptors (14), where a cathode (8) is assigned to the region of the electron acceptors (14),
**characterised in that** the interlayer (10) is arranged between the region of the electron acceptors (14) and the cathode (8) and comprises a material which conducts current principally via electrons, where the conductivity of the interlayer is provided by the mobility of electrons.

2. Photovoltaic cell according to Claim 1, **characterised in that** the electron-conducting interlayer (10) comprises TiO₂ or C₆₀.

3. Photovoltaic cell according to Claim 1 or 2, **characterised in that** the conduction band of the electron-conducting interlayer (10) is matched to the highest occupied molecular orbital of the electron acceptor.

4. Photovoltaic cell according to Claim 1, where an (20) anode is assigned to the region of the electron donors (16).
**characterised in that** an interlayer (18) is arranged between the region of the electron donors (16) and the anode (20) and comprises a material which conducts current principally via defect electrons.

5. Photovoltaic cell according to Claim 4, **characterised in that** the defect electron-conducting interlayer (18) comprises PDOT.

6. Photovoltaic cell according to Claim 4 or 5, **characterised in that** the valence band of the defect electron-conducting interlayer (18) is matched to the lowest unoccupied molecular orbital of the electron donor.

7. Photovoltaic cell according to one of the preceding claims, **characterised in that** the interlayer (10, 18) has a band gap which is larger than or equal to the band gap of the photoactive layer (12).

8. Photovoltaic cell according to one of the preceding claims, **characterised in that** the interlayer (10, 18) is semitransparent..

## Revendications

1. Cellule photovoltaïque organique comportant une couche photoactive (12) comprenant un composant de polymère conjugué et un composant de fullerène et deux électrodes (8, 20), dans laquelle une intercouche (10) présentant une conductivité asymmétrique est agencée entre au moins l'une des électrodes et la couche photoactive (12), dans laquelle une conductivité asymmétrique est indicative d'une mobilité asymmétrique pour les différents porteurs de charges, et dans laquelle la couche photoactive (12) comporte une région comprenant des donneurs d'électrons (16) et une région comprenant des accepteurs d'électrons (14), dans laquelle une cathode (8) est assignée à la région des accepteurs d'électrons (14), **caractérisée en ce que** l'intercouche (10) est agencée entre la région des accepteurs d'électrons (14) et la cathode (8) et comprend un matériau qui conduit le courant principalement via les électrons, dans laquelle la conductivité de l'intercouche est assurée par la mobilité des électrons.

2. Cellule photovoltaïque selon la revendication 1, **caractérisée en ce que** l'intercouche de condution d'électrons (10) comprend du TiO₂ ou du C₆₀.

3. Cellule photovoltaïque selon la revendication 1 ou 2, **caractérisée en ce que** la bande de conduction de l'intercouche de conduction d'électrons (10) est ajustée par rapport à l'orbite moléculaire occupée la plus haute de l'accepteur d'électrons.

4. Cellule photovoltaïque selon la revendication 1, dans laquelle une anode (20) est assignée à la région des donneurs d'électrons (16),
**caractérisée en ce qu'**une intercouche (18) est agencée entre la région des donneurs d'électrons (16) et l'anode (20) et comprend un matériau qui conduit le courant principalement via les électrons de défaut.

5. Cellule photovoltaïque selon la revendication 4, **caractérisée en ce que** l'intercouche de condution d'électrons de défaut (18) comprend du PDOT.

6. Cellule photovoltaïque selon la revendication 4 ou 5, **caractérisée en ce que** la bande de valence de l'intercouche de condution d'électrons de défaut (18) est ajustée par rapport à l'orbite moléculaire non occupée la plus basse du donneur d'électrons.

7. Cellule photovoltaïque selon l'une des revendications précédentes, **caractérisée en ce que** l'intercouche (10, 18) présente une bande interdite qui est plus grande ou égale à la bande interdite de la couche photoactive (12).

8. Cellule photovoltaïque selon l'une des revendications précédentes, **caractérisée en ce que** l'intercouche (10, 18) est semitransparente.
